# EUROPEAN PATENT APPLICATION

(11) **EP 4 622 038 A2**
(43) Date of publication of application: **24.09.2025**
(21) Application number: 25163668.4
(22) Date of filing: 13.03.2025
(51) Int. Cl.: H02J 3/32

(54) **SYSTEM, CONTAINER, AND METHOD FOR CONTAINERIZED ENERGY DELIVERY**

(30) Priority: 18.03.2024 WO PCT/CN2024/082264; 23.09.2024 GB 202413967
(71) Applicant: Cummins Power Generation Inc., Minneapolis, MN 55432 (US)
(72) Inventor: Yan, Sam, Beijing 100102 (CN); Fan, Ying, Beijing 100102 (CN); Bo, Chen, Beijing 100102 (CN); Wang, Kai, Beijing 100102 (CN)
(74) Representative: Cleveland Scott York

(57) **Abstract**

Containerized energy storage is provided. A container may include a power conversion system in a power conversion zone along a first face of the container, the power conversion system configured to convert an AC input power signal to a DC output power signal and to an AC output power signal. The container may include a cooling system comprising a heat exchanger in a heat exchange zone along a second face of the container, the second face opposite from the first face, the heat exchanger configured to exchange heat between (i) a plurality of components of the energy storage system positioned within the container in an energy storage zone positioned between the heat exchange zone and the power conversion zone, and (ii) an environment exterior to the container.

## Description

### CROSS-REFERENCE TO RELATED APPLICATIONS

This application claims Paris Convention priority to International Application No. PCT/CN2024/082264, filed on March 18, 2024. The entire content of the aforementioned application is incorporated herein by reference.

### TECHNICAL FIELD

The present disclosure relates generally to energy storage systems, such as modular battery electric storage systems (BESSs) provided to generate alternating current (AC) output.

### BACKGROUND

Electric storage systems (ESSs), such as battery electric storage systems (BESSs) may be employed for power delivery, storage, conditioning, or other applications. For example, the ESS may be used in transient or remote environments to provide or supplement power generation and storage capability, such as in a case of disaster response.

### SUMMARY

The present disclosure relates generally to energy storage systems, such as modular battery electric storage systems (BESS) provided to generate alternating current (AC) output.

In some aspects, the techniques described herein relate to a system for containerized energy delivery including: a container including: an energy storage system; a power conversion system in a power conversion zone along a first face of the container, the power conversion system configured to convert an AC input power signal to a DC output power signal and to an AC output power signal; and a cooling system including a heat exchanger in a heat exchange zone along a second face of the container, the second face opposite from the first face, the heat exchanger configured to exchange heat between (i) a plurality of components of the energy storage system positioned within the container in an energy storage zone positioned between the heat exchange zone and the power conversion zone, and (ii) an environment exterior to the container.

In some aspects, the techniques described herein relate to a system, wherein: the power conversion system includes a DC link; the plurality of components includes a plurality of battery cells, the plurality of battery cells coupled with the DC link; the container includes a fluid channel in the energy storage zone, the fluid channel configured to transfer the heat to a fluid in the fluid channel; and the heat exchanger is configured to: receive the fluid from the fluid channel; and transfer the heat from the fluid to the environment.

In some aspects, the techniques described herein relate to a system, wherein the power conversion system is configured to generate the AC output power signal and the DC output power signal from the DC link.

In some aspects, the techniques described herein relate to a system, wherein: the power conversion system includes a first circuit configured to couple a first output of the power conversion system with the DC link according to a galvanic isolation of a transformer between the first output and the DC link, the transformer positioned in the power conversion zone, the first circuit including at least one of: an inverter configured to generate the AC output power signal using energy received from the DC link; or a converter configured to generate the DC output power signal using energy received from the DC link; and the power conversion system includes a second circuit spaced vertically from the first circuit, the second circuit configured to couple a second output of the power conversion system with the DC link.

In some aspects, the techniques described herein relate to a system, further including a controller configured to cause at least one of the first circuit or the second circuit to transfer energy from the DC link to the energy storage system based on a state of the energy storage system.

In some aspects, the techniques described herein relate to a system, further including a controller configured to: detect a quantity and arrangement of a plurality of battery modules stored in a plurality of sub-zones of the energy storage zone; and control a charging or discharging of the energy storage system based on the detected quantity and arrangement, wherein the energy storage system is a battery storage system and the plurality of components of the energy storage system are battery cells of the plurality of battery modules.

In some aspects, the techniques described herein relate to a system, wherein: a first nominal dimension between the first face and the second face is 6.1 meters (twenty feet); a second nominal dimension of the container, perpendicular to the first nominal dimension, is 2.6 meters (eight feet six inches); and a third nominal dimension of the container, perpendicular to the first nominal dimension and the second nominal dimension, is 2.4 meters (eight feet).

In some aspects, the techniques described herein relate to a system, further including a controller configured to: receive an indication of power availability from a source device configured to receive the AC output power signal; detect a state of charge (SoC) of the energy storage system; and select between the provision of the AC output power signal and the DC output power signal based on the indication and the SoC.

In some aspects, the techniques described herein relate to a system, wherein the power conversion system further includes a plurality of circuits including: a first circuit configured to provide the AC output power signal simultaneously to the provision, by a second circuit, of the DC output power signal; and the second circuit.

In some aspects, the techniques described herein relate to a system, wherein the heat exchanger is a condenser of a chiller, the fluid includes a refrigerant, and the cooling system further includes a compressor configured to compress the refrigerant.

In some aspects, the techniques described herein relate to a container for energy delivery including: a battery system in an energy storage zone of the container; a power conversion system in a power conversion zone along a first face of the container, the power conversion system configured to convert an AC input power signal to a DC output power signal and an AC output power signal, the DC output power signal configured to recharge battery cells of the battery system; and a heat exchanger in a heat exchange zone along a second face of the container.

In some aspects, the techniques described herein relate to a container, wherein: a first nominal dimension between opposite faces of the power conversion zone and the heat exchange zone is 3 meters (ten feet); a second nominal dimension of the container, perpendicular to the first nominal dimension, is 2.6 meters (eight feet six inches); and a third nominal dimension of the container, perpendicular to the first nominal dimension and the second nominal dimension, is 2.4 meters (eight feet).

In some aspects, the techniques described herein relate to a container, wherein the battery cells are thermally coupled with a fluid; and the container includes a user interface for a fire suppression system at one of the first face or the second face, the user interface configured to receive an input to cause the fire suppression system to discharge a suppression agent configured to manage thermal events of the battery system.

In some aspects, the techniques described herein relate to a container, wherein the second face is opposite from the first face, the heat exchanger configured to: receive a fluid from the energy storage zone of the container, the energy storage zone positioned between the first face and the second face; and transfer heat from the fluid to an exterior face of the container to cause the heat to be exhausted out of the exterior face.

In some aspects, the techniques described herein relate to a container, wherein the container includes: a coolant loop including a fluid channel configured to convey a fluid between the heat exchanger and the battery system; and a fan configured to exhaust air to generate negative pressure within the container.

In some aspects, the techniques described herein relate to a container, including: a plurality of sub-zones including mounting rails and assembly members configured to receive a plurality of energy storage modules of the battery system, each energy storage module of the plurality of energy storage modules including a plurality of battery cells, wherein: a DC link is coupled with multiple energy storage modules of the plurality of energy storage modules, the multiple energy storage modules connected in series.

In some aspects, the techniques described herein relate to a container, wherein the container includes a cooling system fluidically coupled with each of the plurality of energy storage modules, via a fluid coupling of each of the plurality of energy storage modules, wherein each of the plurality of energy storage modules are arranged along, and are removable through, an exterior access surface of the container.

In some aspects, the techniques described herein relate to a container, further including a controller configured to: detect a quantity of parallel groups of battery cells; and control a rate of charging of the battery system based on the detected quantity.

In some aspects, the techniques described herein relate to a container, further including a controller configured to: receive an indication of power availability from a source device configured to receive the AC output power signal, the indication embedded in the DC output power signal; detect a state of charge (SoC) of the battery system; and select between the provision of the AC output power signal and the DC output power signal based on the indication embedded in the DC output power signal and the SoC.

In some aspects, the techniques described herein relate to a container, wherein the power conversion system includes a first circuit and a second circuit, the first circuit configured to receive energy from the battery system while the second circuit provides energy to the battery system.

In some aspects, the techniques described herein relate to a method for containerized energy delivery including: providing, via power conversion circuitry in a power conversion zone of a container, an alternating current (AC) output power signal generated from a battery system; and exchanging heat generated by the power conversion circuitry, via a fluid, between battery cells of the battery system and an exterior face of the container, the battery cells positioned in an energy storage zone of the container, the energy storage zone positioned between the power conversion zone and a heat exchange zone.

In some aspects, the techniques described herein relate to a method, further including: receiving an indication of a cessation of a mode of operation corresponding to the provision of the AC output power signal; terminating, responsive to the indication, the provision of the AC output power signal; and providing, subsequent to the termination, a DC power signal to charge the battery cells of the battery system using energy received from a source device.

In some aspects, the techniques described herein relate to a method, further including: circulating the fluid via a closed loop including a heat exchanger along the exterior face.

In some aspects, the techniques described herein relate to a method, further including: detecting a quantity of battery modules; and controlling a charging rate or discharging rate of the battery system based on the detected quantity.

In some aspects, the techniques described herein relate to a method, further including: monitoring, via a controller, a first condition of the container; monitoring, via the controller, a second condition of a user interface positioned at one of a first face or a second face; and generating a control signal for a fire suppression system based on the first condition and the second condition.

### BRIEF DESCRIPTION OF THE DRAWINGS

FIG. 1 is a block diagram of a system for containerized energy delivery, according to some embodiments.
FIG. 2 is an isometric view of a container, such as the container of FIG. 1, according to some embodiments.
FIG. 3 is a diagram of a power delivery system including the containerized energy storage system of the container of FIG. 1, according to some embodiments.
FIG. 4 is a thermal schematic of a container, such as the container of FIG. 1, according to some embodiments.
FIG. 5 is a cutaway diagram of a container, such as the container of FIG. 1, according to some embodiments.
FIG. 6A is an isometric view of battery packs in an energy storage zone including various subzones of a container, such as the container of FIG. 1, according to some embodiments.
FIG. 6B depicts a top view of the battery packs in the energy storage zone of the container, according to some embodiments.
FIG. 6C depicts an isometric view of a portion of the battery packs in the energy storage zone of the container provided in FIG. 6A, according to some embodiments.
FIG. 6D depicts an isometric view of a portion of the battery packs in the energy storage zone of the container provided in FIG. 6A, according to some embodiments.
FIG. 7 is a block diagram illustrating an architecture for a computer system that can be employed to implement elements of the systems and methods described and illustrated herein.
FIG. 8 is a flow chart illustrating a method of energy control for a containerized energy storage system.
FIG. 9A is an isometric view of a container, according to some embodiments.
FIG. 9B is a reverse isometric view of the container of FIG. 9A, according to some embodiments.
FIG. 10 is a flow chart illustrating a method for containerized energy delivery, according to some embodiments.

### DETAILED DESCRIPTION

Following below are more detailed descriptions of various concepts related to, and implementations of methods, apparatuses, and systems for containerized energy storage systems. Before turning to the figures, which illustrate certain exemplary embodiments in detail, it should be understood that the present disclosure is not limited to the details or methodology set forth in the description or illustrated in the figures. It should also be understood that the terminology used herein is for the purpose of description only and should not be regarded as limiting.

Referring to the figures generally, the various embodiments disclosed herein relate to systems, containers, and methods for energy delivery, such as to provide a containerized energy storage system (CESS). For example, a CESS can conform to a dimensional or functional standard to aid the transportation, setup, thermal management, and other aspects of the CESS. Such a standard can include, for example, a presence of corner castings configured to mate with lifting and securing equipment, or twist locks. The twist locks can be configured to mate with the corner castings to vertically stack instances of the CESS or other like unitary containers. For example, the containers can conform to or substantially conform to an international standards organization (ISO) standard for a ten- or twenty-foot container.

The containerized energy storage system can include or be structured and/or sized to fit within a container (e.g., can have one or more dimensions within a nominal tolerance of corresponding dimension(s) of an ISO shipping container), such as a unitary container. The unitary container is configured to include multiple zones, which may, in turn, include subdivisions referred to as sub-zones. Some or all of the zones (including the sub-zones) may be accessible via a corresponding door, service panel, or other access surface of the exterior of the unitary container.

The system can include a cooling system in a heat exchange zone including a first face. The cooling system can be configured to pass a fluid through at least an energy storage zone to transfer heat from the fluid and the energy storage zone and exhaust the heat to an exterior of the unitary container from a heat exchanger of the heat exchange zone. In some implementations, the containerized energy storage system may be sized equal to (e.g., within a threshold of the size of or to fit within the dimensions of) a standardized shipping container, such as a standardized ISO container. According to some such implementations, it may be easier and/or more economical to ship the containerized energy storage system from one location to another as a result of the standardized size.

The unitary system can include a power conversion system having one or more circuits configured to exchange power according to an AC signal. The power conversion system can be positioned opposite from the cooling system (e.g., in a power conversion zone along a second face opposite from the first face). Each of the circuits can include a power input or power output. Some circuits can be selectively controlled (e.g., via an instruction of a controller) to selectively operate as an input or an output. Any of the circuits can be configured to operate with at least one of an alternating current (AC) or direct current (DC) signal. The energy storage zone can include an energy storage system, such as a battery system. For example, various subzones of the energy storage zone may be selectively populated according to an operating voltage, environmental condition, or energy storage capacity. According to implementations including a battery system, the various cells of the battery system can be arrayed into a set of parallel strings to form a DC link. According to further implementations, a DC link may be otherwise provided. The circuits of the power conversion system can source energy for output signals from the DC link or receive energy from input signals to provide energy to the energy storage system via the DC link.

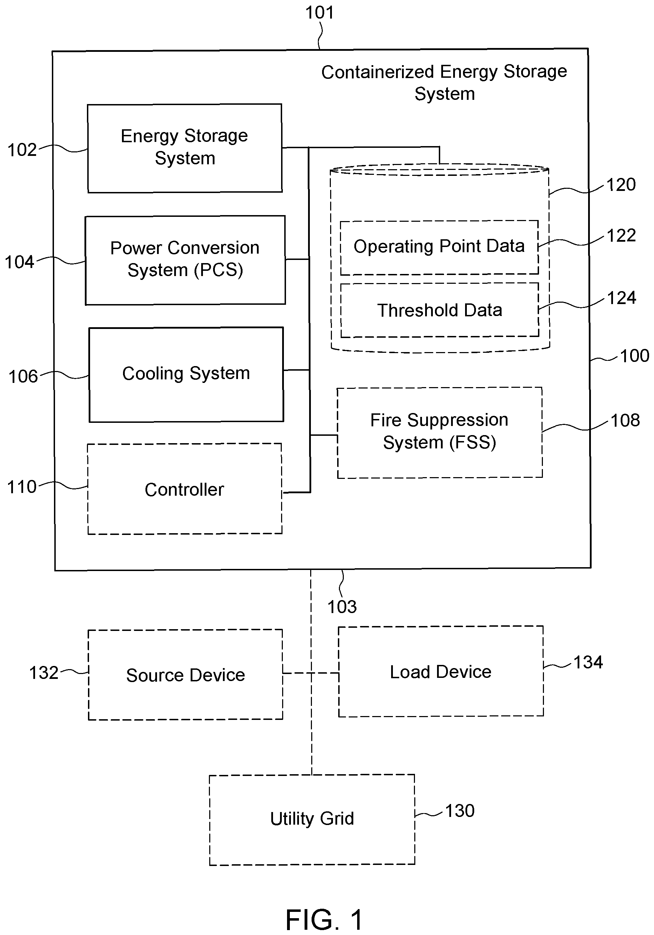

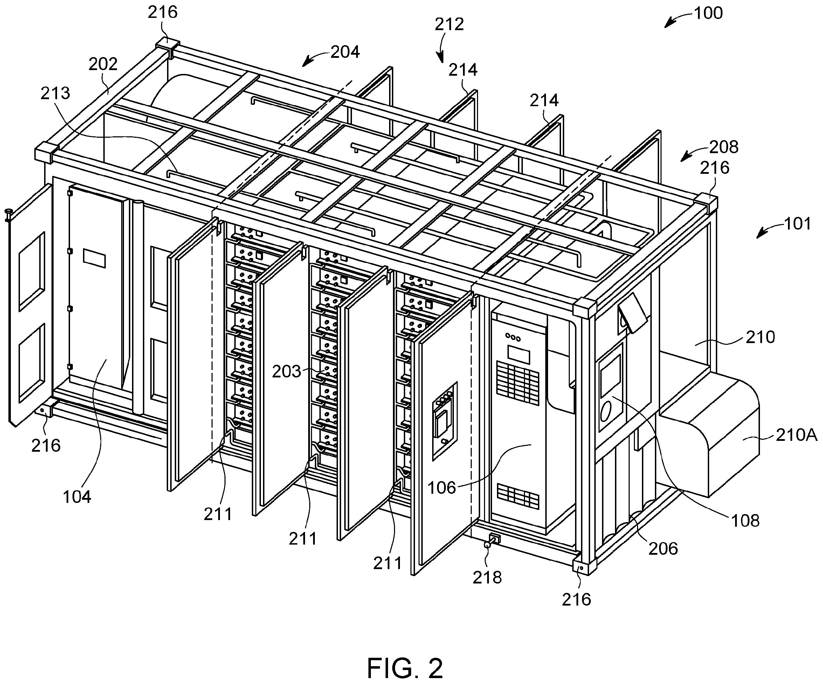

Referring to FIG. **1****,** a system for containerized energy delivery includes a container 101. The container 101 can be a unitary container, such as an integrated container for transporting goods. The container 101 includes (e.g., houses, stores, supports, is populated with) an energy storage system 102. The container 101 includes a power conversion system (PCS) 104 disposed in a power conversion zone (e.g., power conversion zone 204 depicted in FIG. 2) along a first face of the container 101. The PCS 104 is configured to convert an alternating current (AC) input power signal to a direct current (DC) power signal and to an AC output power signal. The container 101 includes a cooling system 106. The cooling system 106 includes a heat exchanger in a heat exchange zone (e.g., heat exchange zone 208 depicted in FIG. 2) along a second face of the container 101, the second face opposite from the first face. The heat exchanger is configured to exchange heat between (i) components of the energy storage system positioned within the container (e.g., batteries) and (ii) an environment exterior to the container 101.

The PCS 104 can include a DC link. In some embodiments, the batteries or other energy-storing components of the energy storage system 102 are coupled with (e.g., electrically coupled with) the DC link of the PCS 104. The container 101 can include a fluid channel in the energy storage zone. The fluid channel can be configured to transfer the heat (e.g., from the energy storage zone) to a fluid in the fluid channel. For example, the fluid channel can thermally couple the fluid of the fluid channel with the batteries or other components to transfer heat therefrom. The heat exchanger can receive the fluid from the fluid channel and transfer the heat from the fluid to the environment. This can allow for effective containerization of the components in the container 101, such as to allow for zone-based arrangement of the energy storage system 102, PCS 104, and/or cooling system 106 in the container 101.

The energy storage system 102, PCS 104, and/or cooling system 106 can each include or interface with at least one processing unit or other logic device such as a programmable logic array engine (e.g., the controller 110), or other module configured to communicate with a data repository 120 or database. The controller 110, energy storage system 102, PCS 104, cooling system 106, and/or data repository 120 can include hardware elements, such as one or more processors, logic devices, or circuits. A circuit may refer to or include system of interconnected components designed to direct and control the flow of energy, signals, or matter. For example, an electrical circuit can include components such as transformers, capacitors, and transistors connected with wires and powered by a voltage source like a battery system. The electrical circuit can transfer electrical energy to or from the energy storage system. A fluidic circuit can include components like pumps, valves, and pipes configured to direct the flow of a fluid (e.g., refrigerant) along a fluid channel. For example, the fluidic circuit can circulate the fluid to transfer heat between components of the container and 101 an environment exterior to the container 101.

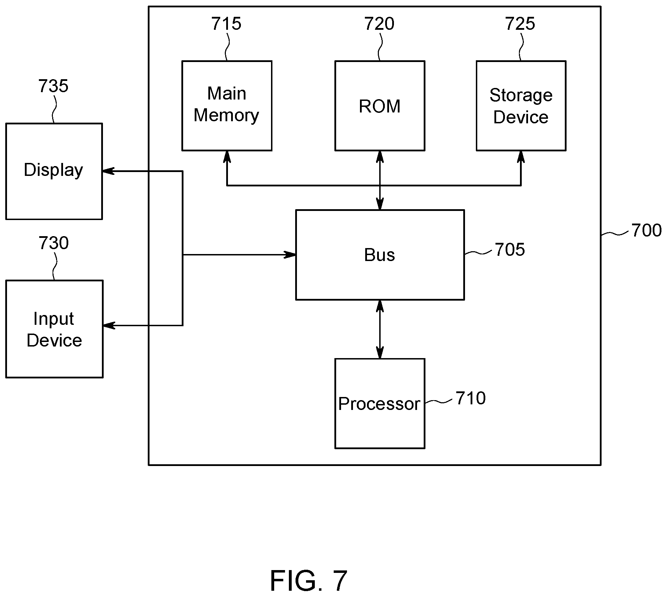

For example, the CESS 100 can include one or more components or structures of functionality of computing devices depicted in FIG. 7. In some embodiments, various portions of the CESS 100 can share one or more components. For example, an energy management system (EMS) can include a processor coupled with memory and communicatively coupled with a further processor of the controller 110 configured to execute various of the operations disclosed herein.

The data repository 120 can include one or more local or distributed databases and can include a database management system. The data repository 120 can include computer data storage or memory and can store one or more of operating point data 122 or threshold data 124.

The operating point data 122 can include a condition of the energy storage system 102, such as a condition related to one or more cells (e.g., battery cells) of a battery system of the energy storage system. For example, the energy storage system can consist essentially of the battery system, in some embodiments. The condition can include a state of charge (SoC) on a cell, pack, rack, or system basis. The condition can include a thermal load or temperature information for one or more of the cells or an element associated therewith (e.g., a cold plate, refrigerant or other fluid coolant, or ambient environment interior or exterior to the container 101). The condition can include an error state such as a loss of communication with a sensor or processor, a sensed overcurrent, overtemperature, overvoltage, undervoltage, ground fault, connection misfire, or so forth. The condition can include a capacity such as a sensed capacity (e.g., according to a number of populated subzones).

For example, a battery system can detect a number of populated zones during operation (e.g., for a hot-swappable battery pack), at system startup/initialization, or according to another indication such as a configuration file. The operating point data 122 can include a flow of power to or from the CESS 100 along one or more circuits of the PCS 104. For example, the operating point data 122 can include a quantity of power received at or provided from a power port of each of the one or more circuits. Such an indication can include a voltage, current, power factor, or other aspects of power delivery.

The operating point data 122 can include a power characteristic of one or more sources, such as a cost, indication of greenness (e.g., associated emissions such as carbon dioxide equivalent emissions), power factor, or the like. In some instances, for at least some sources, such a power characteristic can include a prediction of availability. For example, a solar source such as a solar-thermal or photovoltaic system can indicate a cessation of availability at nightfall, a generator set (genset) can indicate a cessation of availability upon an exhaustion of a fuel source, or a wind system can indicate a cessation of availability according to ambient weather conditions. The operating point data 122 can include a load demand by one or more load devices 134.

The operating point data 122 can include a selected operating mode. The CESS 100 can detect the operating mode according to a receipt of a message by the controller 110, a mechanical switch, or a sensed connection. Operating modes can include, for example, a grid forming (VF) mode wherein one or more circuits of the PCS 104 generate a voltage and frequency to form an electrical grid. Operating modes can include a grid following (PQ) mode, wherein one or more circuits of the PCS 104 adjusts an output power and reactive power to follow a grid voltage and frequency. For example, in the PQ mode, a CESS 100 can follow a grid established by another CESS 100 or other power source such as a generator set or a utility grid 130. In some embodiments, the CESS 100 selects the operating mode according to a negotiation between multiple of the CESS 100 to determine a leader CESS 100 and one or more follower CESS 100.

The operating modes can include an island mode, wherein the CESS 100 operates separately from a utility grid 130, such as to rely on its internal stored energy to meet power demands. The operating modes can include a load shifting mode, such as to time-shift demand according to threshold data 124. For example, the CESS 100 can provide energy via an AC output of a circuit of the PCS 104 responsive to a detected demand exceeding a first threshold and providing energy from an input to a PCS 104 responsive to a demand (or SoC) falling below a second threshold. Such an implementation can, for example, aid in the use of intermittently available power sources such as photovoltaic, wind, etc.

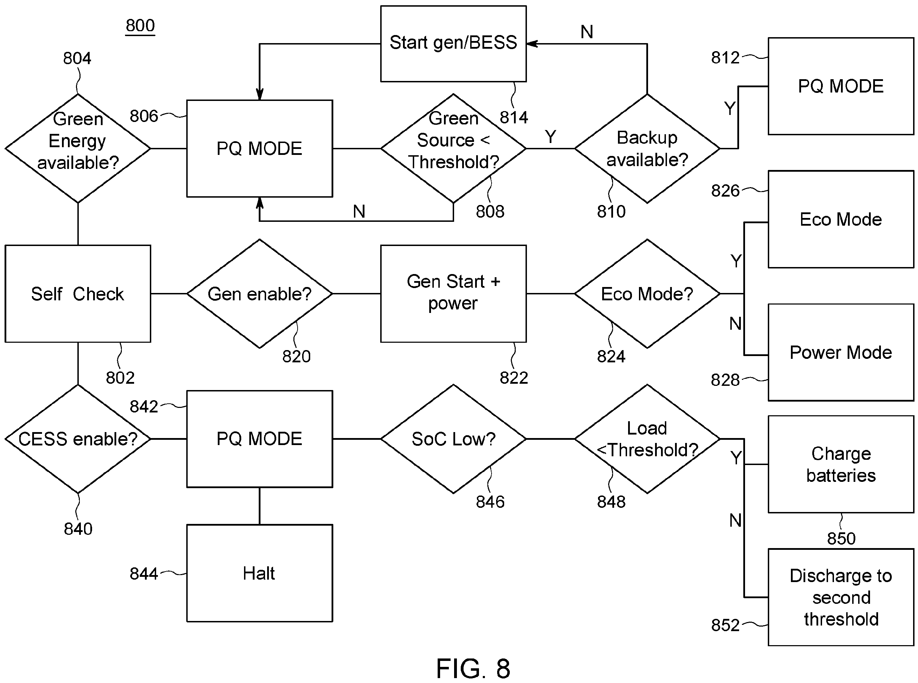

The threshold data 124 can refer to one or more threshold values and/or an action corresponding to the one or more threshold values. In this way, the threshold data 124 can correspond to an operation of a controller 110 such as a programmable logic controller (PLC) of the controller 110 as may be implemented according to various circuits such as relays, general purpose processors, or application specific PLCs. For example, various branches of the method 800 of FIG. 8 can correspond to such thresholds and corresponding actions. Threshold values can include, for example, a SoC value, a quantity of green energy of a grid, any of the temperatures disclosed herein, a load demanded at a load device, or a quantity of energy available from a source device. Actions corresponding to the values include any of the actions discussed herein.

The CESS 100 includes at least one energy storage system 102, which can sink, source, and/or store energy. Some illustrative examples of energy storage systems include battery systems, supercapacitor systems, thermal storage systems, flow-batteries, or capacitive deionization systems. Various examples of the present disclosure are provided with reference to a battery system, however, such examples may not be construed as limiting. For example, battery cells can be substituted for supercapacitor cells, or thermal storage modules in some embodiments. In an example of a battery-based energy storge system 102, the energy storage system 102 includes series combinations of cells (sometimes referred to as strings). The strings may be arrayed into parallel configurations (sometimes referred to as banks). A (battery) pack (sometimes referred to as a battery module) can include one or more strings. For example, a battery pack can include a series string of forty-four cells, in some embodiments. Each battery pack may further include a battery controller (e.g., load balancer), casing, voltage or temperature sensors, or thermal management system.

In some embodiments, the thermal management system of the battery pack may be configured to interface with the CESS 100 cooling system 106. For example, the thermal management system can include a fluid inlet to receive a fluid (e.g., a refrigerant) from the cooling system 106 and a fluid outlet to expel the fluid. The fluid can couple with the battery cells (e.g., directly, via a cold plate, or otherwise). The fluid can transfer heat, via the coupling, with the battery cells to condition the battery pack. For example, batteries exceeding a threshold temperature can transfer heat to the fluid to cool the battery cells, and batteries below a threshold temperature can source heat from the fluid to warm the battery cells.

Battery packs can be arrayed into racks via electrical connections therebetween. Like the packs themselves, battery racks may also be referred to as battery modules, without limiting effect. Thus, references to a battery module can refer to either of packs or racks thereof (e.g., modules or submodules). For example, the forty-four cell packs referred to above can be combined in series to form a series connected rack. To provide some particular examples, five or six packs may be included in a rack to form a 1267-volt, or 704-volt string according to a nominal 3.2 volt per cell chemistry. Such illustrative embodiments are not limiting, and other single or multi-string banks may be employed according to various embodiments of the present disclosure according to, for example, a number of packs, cell chemistries, cell sizes, charging voltages, and so forth. However, certain of the example battery packs provided herein may be particularly suited to suitable thermal and electrical performance within the examples of the constrained dimensions of the containers described herein, for at least some loads as may be operated according to a coupling with the CESS 100.

A battery pack or rack (or other module) may be assembled as a line-replaceable unit. For example, the battery packs or racks can be individually removable and replaceable according to a removal or bypass of the fluid couplings with the cooling system 106, and the electrical connections therebetween. For example, at mechanical and fluidic couplers for the battery packs or racks can be positioned along an exterior access surface such that they can be removed by an operator exterior to the container 101.

A battery combiner can couple or decouple battery modules from a DC link according to a condition of the DC link. For example, a battery combiner can couple racks to a DC link to form a bank. The battery combiner can operate according to messages from a controller 110, such as via solid state relays, solenoids, motor operated switches, or so forth. In some embodiments, the battery combiner includes a mechanically engageable connector (e.g., relay, switch, emergency stop button, or the like) to couple or decouple battery modules with the DC link. In some embodiments, a set of one or more battery racks (e.g., two battery racks) can include a battery combiner to couple the racks (or packs thereof) to the DC link. In some embodiments, coupling can be on a per-rack basis, per-pack basis, or other module basis according to a condition of one or more modules. For example, the battery combiner can bypass one or more packs or cells, or cut out a rack responsive to a condition of the one or more packs or cells, the condition detected by the controller 110.

In some embodiments, the DC link is coupled to battery strings without an intervening converter, such that the DC link is a floating voltage link, where a voltage of the SC link depends upon a SoC of the battery cells. In some embodiments, a DC-DC converter can separate the battery strings from the DC link to regulate a voltage of the DC link.

The racks may be positioned in various sub-zones of a zone for the batteries. For example, an access surface can correspond to one or more subzones, such that all the battery modules of a subzone (e.g., one or more racks) can be inspected, serviced, removed, or replaced from a same door, panel, or other access surface of the CESS 100.

The CESS 100 includes at least one PCS 104 to exchange power between at least one circuit of the PCS 104, and the DC link. The PCS 104 can include multiple circuits to receive or transmit power signals via power exchange between the DC link and ports, such as output ports or input ports. Any of the circuits can be fixed function or can include at least one selectable component. For example, some circuits can only receive power signals while other circuits can only transmit power signals. Some ports can select-ably receive or transmit power signals according to a mode of operation indicated by the controller 110. Various implementations of circuits can operate simultaneously, or to the exclusion of other circuits. For example, in some embodiments, the CESS 100 (e.g., the PCS 104) further includes a first circuit and a second circuit, where the first circuit is configured to provide the AC output power signal (e.g., to provide power to a load device 134) simultaneously to the provision, by the second circuit, of a DC output power signal (e.g., to provide power to the DC link to charge the CESS 100). Some illustrative examples of circuits are provided henceforth. Any of their features may be selectable, by the controller 110 actuating various controls to modulate operation of the circuits, or fixed function, according to various embodiments of the present disclosure.

The PCS 104 can be configured to generate the AC output power signal and the DC output power signal from the DC link (e.g., from energy sourced from battery cells electrically coupled with the DC link). The PCS 104 can include a first circuit, which can be configured to couple a first output of the PCS 104 with the DC link according to a galvanic isolation of a transformer between the first output and the DC link, the transformer positioned in the power conversion zone, in some embodiments. The first circuit can include an inverter configured to generate the AC output power signal using energy received from the DC link. The first circuit can include a converter configured to generate the DC output power signal using energy received from the DC link.

The first output can receive a power signal from a first source device 132. For example, the first source device 132 can include a renewable energy source such as a solar photovoltaic (PV) panel, solar-thermal, or other solar system, wind or tidal turbine, vehicle to grid/load (V2G/L) system. In some embodiments, the first circuit is configured to receive an AC power signal (e.g., the first circuit can include an AC to DC converter). For example, the PV panel may be coupled with an inverter to provide the AC power signal. In some embodiments, the first circuit is configured to receive a DC power signal such as a non-inverted power signal from the PV panel. The first circuit can include a DC-to-DC converter or an inverter, according to an input power signal type, to adapt the received power signal to a voltage for the DC link to charge battery cells or other energy storage components, or otherwise employ the received power (e.g., to provide power via an output power signal of another circuit). For example, the first circuit can provide a regulated output voltage which may differ from a voltage of the DC link.

A second circuit can be configured to couple with a utility grid 130. For example, the second circuit can operate in a first mode to provide an AC power signal to the utility grid 130 (e.g., in a follower mode). The second circuit can generate an AC power signal at a 400-volt or 690-volt root means squared (RMS) value, in some embodiments. The second circuit can be configured to output the AC power signal as a single phase, three phase, or other signal according to various embodiments. For example, the second circuit can include a single-phase or three-phase inverter between the DC link and the output port.

The second circuit can operate in a second mode to receive an AC power signal from the utility grid 130. For example, the second circuit can be configured to recive an AC power signal at a 400-volt or 690-volt RMS value. The second circuit can be configured to receive the AC power signal as a single phase, three phase, or other signal. The second circuit can include an AC to DC converter between the input port and the DC link. In some embodiments, the input port and output port of the second circuit include same electrical terminals for electrical sink or sources, according to a selected mode of the second circuit, as indicated by the controller 110.

In some embodiments, the second circuit includes a transformer or otherwise implements galvanic isolation between the DC link and the output port. For example, the second circuit can include or interface with a 400-volt or 690-volt transformer to provide the galvanic isolation. In some embodiments, the transformer or other galvanic isolation device may be omitted, or included in any of various circuits of the PCS 104. For example, where the CESS 100 is configured to interface with a transmission line voltage (e.g., 10,500 volts), such isolation may be omitted to reduce transformer losses. However, the CESS 100 can be configured to couple with a separate transmission line transformer provide the isolation. For example, the CESS 100 can be configured to couple with a transmission line transformer interior or exterior to a container 101 thereof. Such an example is not intended to be limiting. For example, the first circuit can include a transformer in a power conversion zone (which may sometimes be referred to as a first zone). A second circuit of the PCS 104 may be configured to couple a second output of the PCS 104 with the DC link. The first and second circuits may be spaced vertically from one another. Moreover, references to outputs should not be construed to exclude receipt of a power signal by a corresponding circuit. For example, at least one of the first output or the second output are configured to operate based on an instruction of the controller 110, in some embodiments. For example, the controller 110 can cause at least one of the first circuit or the second circuit to transfer energy from the DC link to the energy storage system based on the state of the energy storage system (e.g., the SoC, temperature, etc.).

A third circuit of the PCS 104 can be configured to receive a power signal from a generator set source device 132. For example, the PCS 104 can receive an AC power signal from a 400V input port of the third circuit. The third circuit can further include an AC to DC converter to provide the power of the power signal to the DC link to charge the battery cells of the battery system.

A fourth circuit can be configured to couple with the generator set source device 132 and a load device 134 in a hybrid operational mode. In the hybrid operational mode, the controller 110 can cause the generator set source device 132 to operate within a predefined operating range (e.g., an efficiency band) or according to an average power demand. The CESS 100 can provide power to the load device 134 when the power demand exceeds the power generated by the generator set source device 132. The CESS 100 can source power from the generator set source device 132 when the power generated by the generator set source device 132 exceeds the power demand. The fourth circuit can include a transformer or other galvanic isolation device between an output and a load device 134. In some embodiments, the transformer is positioned between the load device 134 and another source device such as the generator set source device 132, to protect the source device 132.

In some embodiments, the fourth circuit (or other circuits of the PCS 104) includes a communications channel with a source device 132 or load device 134. In some embodiments, the fourth circuit (or any other circuits of the PCS 104) are configured to detect power signal characteristics such as a voltage sag or frequency deviation indicative of a power demand or source of another device. Such power signal characteristics may be referred to as embedding indications in the power signal. A source device 132 and load device 134 can likewise include a communications channel to communicate demand information, or detect demand information according to the power signal characteristics. According to such communications, the controller 110 of the CESS 100 can cause the generator set source device 132 to increase a power production level responsive to a condition detected by the controller 110. For example, the condition can include a state of charge or other condition of the battery system. During hybrid operation, the controller 110 can detect when the SoC falls below a threshold value, and transmit a message to the generator set source device 132 to increase power generation. Conversely, controller 110 can detect that the SoC exceeds a threshold value, and transmit a message to the generator set source device 132 to decrease power generation (e.g., reduce a load, RPM, or shutoff).

Hybrid operation is not limited to the generator set source device 132. For example, the controller 110 can implement the hybrid mode of operation including a cascade of energy sources according to a cost, green energy usage, or the like. In an example embodiment, the controller 110 can implement hybrid operation to include a provision of renewable energy from the first circuit. Where energy demand exceeds a supply of the first circuit, the controller 110 can cause the CESS 100 to provide stored energy (e.g., according to an energy supply or demand threshold of the threshold data 124). Responsive to a detection of an energy demand which exceeds stored energy and renewable energy from the first circuit, the controller 110 can cause the generator set source device 132 to operate in an efficiency band. Responsive to a detection of an energy demand which exceeds stored energy, renewable energy from the first circuit, and the efficacy band power of the generator set source device 132, the controller 110 can cause the generator set source device 132 to operate in a power band.

The CESS 100 includes at least one cooling system 106 configured to exchange heat between the other components of the CESS 100 and an environment exterior to the container 101 to condition the components thereof. Although referred to as a cooling system 106, the conditioning can include warming (e.g., heating) or cooling components, according to various embodiments or environments. For example, in a cold-ambient environment, the cooling system 106 can warm battery cells with heat generated by the PCS 104, or via a heater element.

The cooling system 106 can include a heat exchanger (e.g., chiller) to exchange heat with an ambient environment. For example, the heat exchanger can receive a fluid passed through a zone of the container 101 including components of the energy storage system 102 (e.g., battery cells). The heat exchanger can pass the fluid along a radiator positioned along an exterior face of the CESS 100 to reduce a difference between the fluid temperature and the environmental temperature (e.g., transfer heat from the fluid to an exterior face of the container 101). The fluid may be conveyed to the heat exchanger along a refrigerant loop, such as via a pump, convection currents, or otherwise. In some embodiments, the refrigerant loop can include a same phase of fluid throughout the loop (e.g., a liquid-to-liquid phase refrigerant loop such as an ethylene glycol loop). In some embodiments, the refrigerant loop can include a phase change refrigerant (e.g., R-410A). For example, the heat exchanger can be a condenser of a chiller, and the cooling system 106 can include a compressor configured to compress the refrigerant. The cooling system 106 can include an expansion valve, and can include an evaporator.

The container 101 includes a fire suppression system 108, according to some embodiments. The fire suppression system 108 can be configured to detect fire (e.g., according to a particulate matter or ionization sensor, infra-red sensor, flame sensor, temperature sensor, arc-fault sensor). The fire suppression system 108 includes a manually operated control such as a panel accessible via an exterior face of the container 101 (e.g., the first face 202 or the second face 206), in some embodiments. Upon manual activation or detection of indicia of a fire, the fire suppression system 108 can release inert gasses, smothering foams, dry chemical agents, or other fire suppression agents to interrupt chemical reactions of battery cells of the energy storage system 102.

The CESS 100 includes or interfaces with at least one controller 110, according to some embodiments. The controller 110 can include or interface with one or more processors and memory. The processor can be implemented as a specific purpose processor, an application specific integrated circuit (ASIC), one or more field programmable gate arrays (FPGAs), a group of processing components, or other suitable electronic processing components. The processors and memory can be implemented using one or more devices, such as devices in a client-server implementation. The memory can include one or more devices (e.g., random access memory (RAM), read-only memory (ROM), flash memory, hard disk storage) for storing data and computer code for completing the various operations described herein. The memory can be or include volatile memory or non-volatile (e.g., non-transitory) memory and can include database components, object code components, script components, or any other type of information structure for supporting the various activities and information structures of the present disclosure. The memory can be communicably connected to the processor and include computer code or instruction modules for executing one or more processes described herein. The memory can include various circuits, software engines, and/or modules that cause the processor to execute the systems and methods described herein, such as the portions depicted in FIG. 7, hereinafter.

The controller **110** is structured to control, at least partly, the operation of the CESS 100 and associated systems, such as various source or load devices. The controller 110 can cause one or more operations disclosed, such as by employing another element of the CESS 100. For example, operations disclosed as performed by other elements of the CESS 100can be initiated, scheduled, or otherwise controlled by the controller 110.

The controller 110 can include or be coupled with communications electronics. The communications electronics can conduct wired and/or wireless communications. For example, the communications electronics can include one or more wired (e.g., Ethernet, PCIe, AXI, or CAN) or wireless transceivers (e.g., a Wi-Fi transceiver, a Bluetooth transceiver, an NFC transceiver, or a cellular transceiver). The controller 110 can communicatively couple, using the communications electronics, to various components of the CESS 100 or associated equipment (e.g., source devices 132, load devices 134, or a utility grid 130). Communication between and among the components or other devices of the present disclosure can be via any number of wired or wireless connections.

The CESS 100 can further include any number of interface ports 103, corresponding to circuits of the PCS 104. The interface ports 103 can couple with various source devices 132, load devices 134, or combinations of source devices 132 and load devices 134 referred to, collectively, as a utility grid 130. The interface ports 103 are each configured to provide or receive a power signal. In some embodiments, some interface ports 103 can further receive or provide communicative links with source devices 132, load devices 134, or utility grids 130. For example, the controller 110 can provide commands or other messages via the interface ports 103, or receive information such as a content of green power, a cost, a demand, supply, or a prediction of future information via the interface ports 103. Each interface port 103 can include multiple terminals. Some terminals may be configured for a single purpose (e.g., transmission of energy, receipt of energy, and communication). Some terminals may be configured for multiple purposes (e.g., bidirectional current flow with communications signaling embedded in or riding over a power signal).

The controller 110 can be configured to receive an indication of power availability from at least one source device 132 configured to receive the AC output power signal. The controller 110 can detect the SoC of the energy storage system 102 of the CESS 100. Based on the indication and the SoC, the controller 110 can select between the provision of an AC output power signal (e.g., a power output mode) and a DC output power signal (e.g., a recharge mode).

References to source devices 132 and load devices 134 are not intended to limit such devices to a single mode of operation. For example, an electric vehicle can operate as a load device 134 to charge a battery thereof in a first mode of operation and operate as a source device 132 in a vehicle to load (V2L) application in a second mode of operation.

Referring now to FIG. 2, an isometric view of the container 101, such as in which one or more components are populated (e.g., positioned and/or arranged) is provided, according to some embodiments. The container 101, in combination with various of the populated components, may be referred to as a CESS 100. The container 101 and/or arrangement of component(s) in the container 101 can mitigate or prevent exposure of the components to environmental conditions (e.g., dust, caustic chemicals, water). A first face 202 of the container 101 coincides with an outer boundary of a power conversion zone 204, the power conversion zone 204 including the PCS 104. A second face 206 of the container 101 coincides with an outer boundary of a heat exchange zone 208 (sometimes referred to as a second zone), the heat exchange zone 208 including at least a heat exchanger 210 of the cooling system 106. In various embodiments, at least a portion of the heat exchanger 210 can be positioned along the second face 206 (as depicted), proximal to the second face 206 along an adjoining wall perpendicular to the first face 202, or along an upper surface of the container 101.

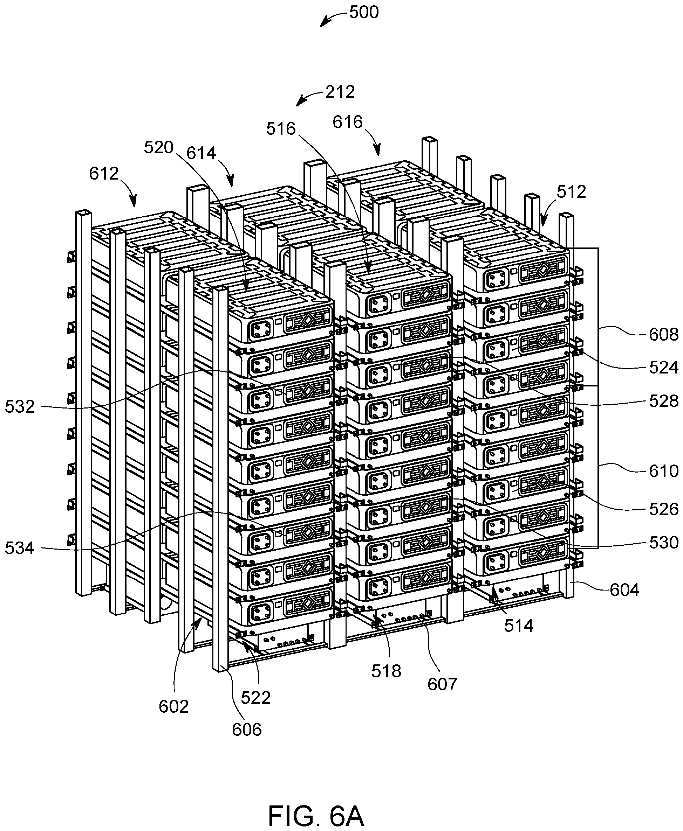

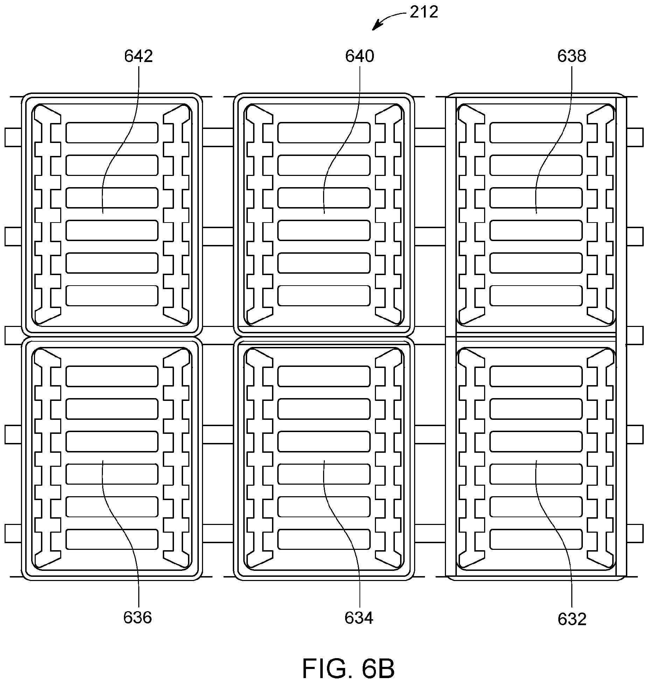

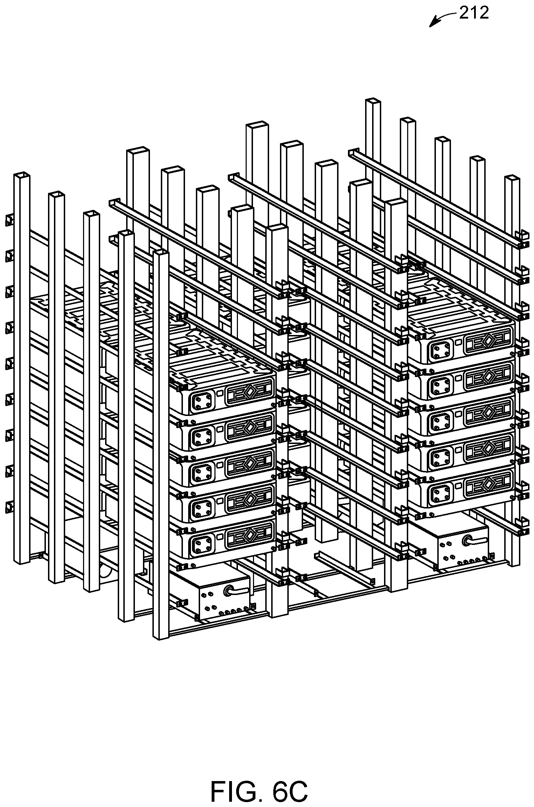

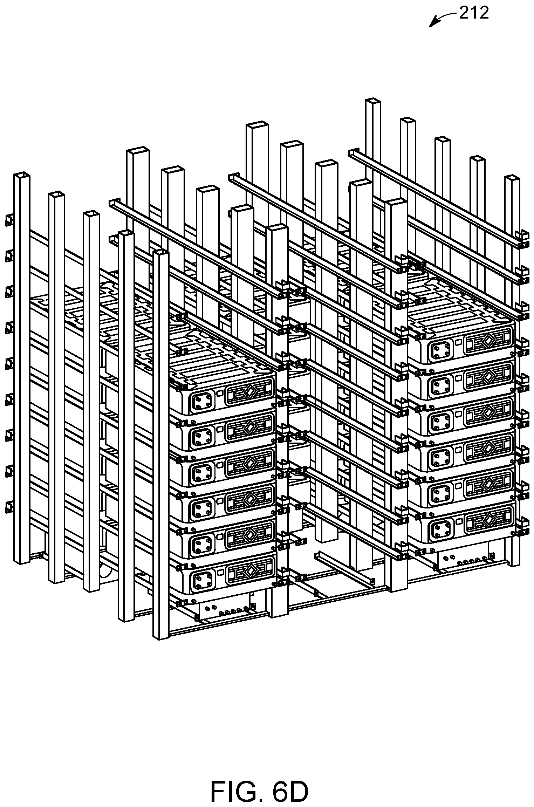

Battery cells of a battery system 203 are positioned in an energy storage zone 212 of the container 101. For example, the battery cells are arrayed into battery packs which are, in turn arrayed into battery racks. Some example geometries of the battery cells are provided with greater detail hereinafter, at FIGs. 6A, 6B, 6C, and 6D. The CESS 100 can operate according to a quantity and arrangement of various subzones of the energy storage zone 212 (e.g., different number of battery cells or different cell configurations), as may be detected by the controller 110. For example, the controller 110 can be configured to detect a quantity and arrangement of a plurality of battery modules stored in any one or more (e.g., a plurality of) sub-zones of the energy storage zone 212, and can control a charging or discharging of the energy storage system 102 (e.g., the energy storage system 102 being a BESS and the plurality of components of the energy storage system 102 being battery cells of the plurality of battery modules) based on the detected quantity and arrangement. For example, the controller 110 can adjust a charge or discharge rate, thermal limit, or state of charge (SoC) threshold according to the quantity and arrangement.

The cooling system 106 includes refrigerant lines to pass a fluid through the power conversion zone 204, heat exchange zone 208, and energy storage zone 212, in some embodiments. The fluid can thermally couple with components of the PCS 104 such as switching devices or filtering components of inverters, DC-DC converters, or transformers. Such coupling may be direct or via intermediate components, such as heat sinks, cooling plates, interface materials, or so forth.

A fluid circuit can extend between the heat exchange zone 208 and the energy storage zone 212. In some embodiments, the fluid circuit further extends into the power conversion zone 204. In some embodiments, the fluid inlets for the components of the power conversion zone 204 source the fluid from fluid outlets 211 of the battery modules of the energy storage zone 212. For example, in an instance where an operating temperature of battery modules and PCS 104 exceed an ambient temperature, fluid at a first temperature (e.g., near-ambient) may be received from the heat exchanger 210 and delivered to the battery module in the energy storage zone 212, where the fluid is conditioned to a second temperature, greater than the first temperature, and is thereafter conveyed to the fluid inlets for the PCS 213, where the fluid is conditioned to a third temperature, greater than the second temperature, and is thereafter returned to the heat exchanger to return the fluid to the first temperature. In some embodiments, a refrigeration circuit can include otherwise arranged elements, such as from the heat exchanger to the inlets for the PCS 213 to the battery modules. In some embodiments, the refrigeration circuit can include separate branches for the inlets for the PCS 213 and the battery modules.

The arrangement of the container 101, power conversion zone 204, heat exchange zone 208, and/or energy storage zone 212 with respect to one another can allow for more effective component connections, airflow, cooling, and/or prevention of moisture ingress. For example, the depicted position of the power conversion zone 204 and heat exchange zone 208 along opposite faces of the container 101 can promote convective cooling from various components thereof (e.g., casings, finned surfaces, etc.), at least according to an increase in surface area. Moreover, such an arrangement can ease access such as by providing multiple surfaces, which can promote physical standoff distances between various connectors, or between conductors and serviceable panels, indicators, and the like. For example, a panel for the fire suppression system 108 is depicted as positioned on the second face 206.

With further reference to the container 101, a first nominal dimension (e.g., length) of the first face 202 of the power conversion zone 204 and the second face 206 of the heat exchange zone 208 can equal 6.1 meters (twenty feet), according to the depicted embodiment of FIG. 2. The depicted vertical dimension perpendicular thereto (e.g., width) can equal 2.6 meters (eight feet six inches), and the remaining perpendicular dimension (e.g., height) can equal 2.4 meters (eight feet). Such nominal dimensions may be exclusive of flaps, hoods, and the like (e.g., a hood 210A of the heat exchanger 210). However, such portions may be removable to ease in the transportation thereof. For example, the container 101 includes a storage area to include such components, in some embodiments.

The container 101 includes access surfaces (depicted as doors 214) to facilitate the removal of various line-replaceable units of the CESS 100. For example, upon a disconnection of fluidic and electrical connections, the various components of the battery system 203, PCS 104, and cooling system 106 may be removed via the access surfaces without further disassembly of the container 101. The container 101 further includes corner castings 216 configured to stack instances of the CESS 100 on each other, or with other containers as may be configured to mate with the corner castings (e.g., ISO ten- or twenty-foot containers sometimes referred to as a container express, CONEX). The corner castings 216 may be couplable with twist locks 218 to secure such stacked containers (e.g., for transport or in use).

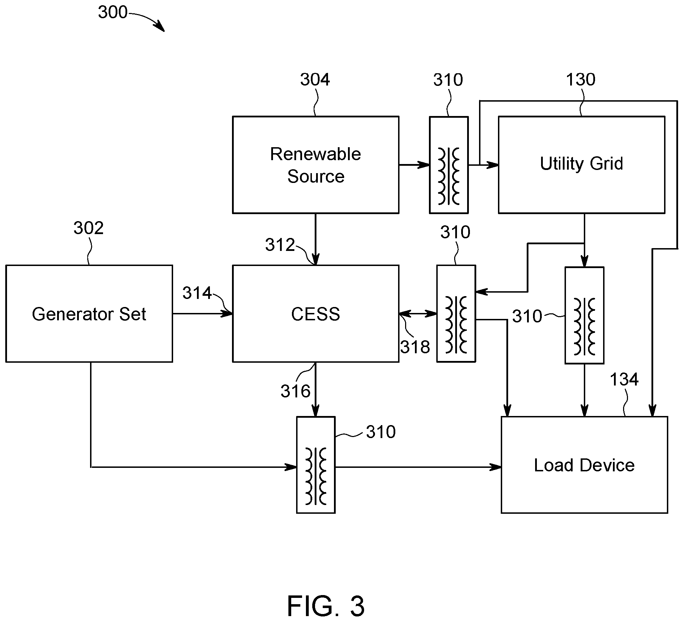

Referring now to FIG. 3, a diagram of a power delivery system 300 including the CESS 100 is provided, according to some embodiments. Some example circuits are shown according to the depicted power delivery system 300. According to various power delivery systems 300 or other operating environments, the CESS 100 can omit, add, or substitute circuits or portions thereof. For example, in some embodiments, certain of the transformers 310 are omitted. In some embodiment, the controller 110 can actuate switching components to cause the PCS 104 to select-ably interface with any components coupled therewith. In some embodiments, modular components of the PCS 104 related to at least one circuit can be physically substituted according to a selected mode of operation (e.g., power sourcing/power sinking or grid forming/grid following).

The CESS 100 couples with a renewable energy source 304 via a first circuit 312 of the PCS 104. The first circuit 312 can be configured to receive a DC or AC power signal from the renewable energy source 304. For example, the renewable energy source 304 can include a PV panel to provide a DC power signal to the first circuit 312, and to provide (via an inverter of the renewable energy source 304), an AC power signal to a transformer 310 to provide energy to a utility grid 130. The omission of an inverter can increase a power efficiency of a conveyance of energy between the renewable energy source 304 and the CESS 100. However, in some embodiments, such as where the renewable source 304 is positioned remote from the CESS 100, an inverter (and transformer) may be included which may improve efficiency to the extent that reductions in transmission losses exceed increases in conversion losses. Further, according to various embodiments of the present disclosure, various of the transformers 310 may be omitted, such as where either of galvanic isolation or voltage conversions are not included between the various nodes of the power delivery system 300. In some embodiments, a controller 110 of the CESS 100 can cause the renewable energy source 304 to selectively supply power to the utility grid 130 or a DC link of the CESS 100. For example, the controller 110 can select a power load according to a comparison of any of the threshold data 124 with a condition of the CESS 100 or devices coupled with the CESS 100, such as an SoC of a battery system 203, a load demand, a portion of green energy, an energy cost, a power characteristic of grid energy, or so forth.

The first circuit 312, like other references to first, second, third, and so on, are merely provided to describe the figures. Such references are not intended to limit the disclosure. For example, the first circuit 312, second circuit 314, and third circuit 316 FIG. 3 need not correspond to the first, second and third circuits described with regard to FIG. 1. Moreover, illustrative examples of circuits can be omitted from or added to various embodiments contemplated according to the present disclosure.

A second circuit 314 of the PCS 104 couples the CESS 100 with a generator set 302. The CESS 100 can receive, via the second circuit 314, an AC power signal from the generator set 302. In some embodiments, a controller 110 of the CESS 100 can modulate the AC power signal. For example, responsive to a comparison of any detected information with the threshold data 124, the controller 110 can cause the generator set 302 to operate in an efficiency band, a power band, to shut off, or so forth.

A third circuit 316 of the PCS 104 couples the generator set 302 with the CESS 100 via a transformer 310. The separation of the second circuit 314 from the third circuit 316 may aid in providing separate signal paths between the generator set 302 and the load device 134. For example, a power signal input from the generator set 302 to the CESS 100, can omit a galvanic isolation device (e.g., transformer 310) to aid in power transfer efficiency, whereas the output to the load device 134 shared with the generator set 302 can include a galvanic isolation device (e.g., transformer 310) to eliminate ground loops, or otherwise comply with grid or other connection standards. The controller 110 can modulate a power output of the CESS 100 from the third circuit 316 and, in some embodiments, of the generator set 302 for the shared output. For example, either of the generator set 302 or the CESS 100 can operate as a leader or follower of a leader/follower pair to source energy to a load device 134 according to a comparison of operating point data 122 with threshold data 124 (e.g., to reduce fuel usage, pollution emission, or for failover redundancy). A fourth circuit 318 couples the CESS 100 with a utility grid 130. The controller 110 can cause the CESS 100 to receive power from, or supply energy to, the utility grid 130 according to comparisons between operating point data 122 and the threshold data 124.

The controller 110 can cause the CESS 100 to receive energy at a DC link to accumulate stored energy (e.g., charge battery cells of the battery system 203) from any of the generator set 302, renewable energy source 304, or utility grid 130 (to include combinations thereof). The load device 134 coupled with the CESS 100 can receive energy from any of the generator set 302 alone, renewable energy source 304 alone, utility grid 130 alone, or any combination thereof, such as a combination including the CESS 100 and the generator set 302 in a hybrid configuration.

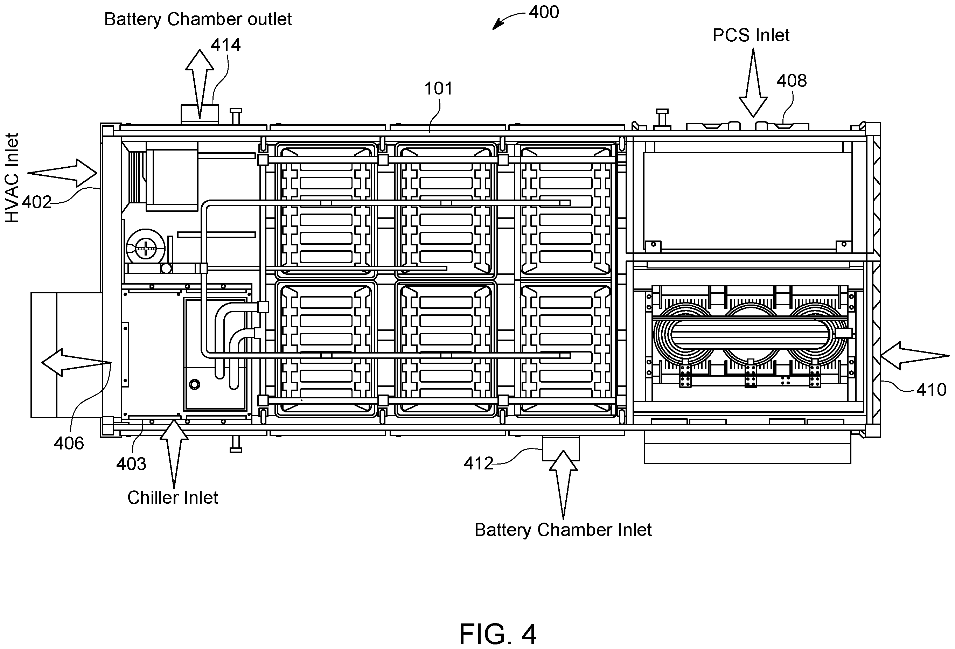

FIG. 4 is a thermal schematic 400 of a container 101, according to some embodiments. The thermal schematic 400 depicts a thermal transfer of air, which may be employed, by the cooling system, in at least some embodiments. For example, the depicted airflow pathways of the CESS 100 may be provided in addition to, or instead of a liquid cooling system. In some embodiments, a fan, blower, or other air moving device of the cooling system ingests air to generate positive pressure within the container 101. An inlet for the air may include an HVAC inlet 402 or a chiller inlet 403, in some embodiments.

In some embodiments, the cooling system 106 exhausts air to generate negative pressure. According to a negative pressure system, vents can ingest air. Accordingly, the HVAC inlet 402 can include non-forced air vents, in some embodiments. Vents may also be referred to as inlets or outlets, such as a chiller outlet 406. A pressure gradient between opposite faces of the container 101 can cause an ingestion of ambient air into one or more of a PCS inlet 408, transformer inlet 410, or battery chamber inlet 412. The flow may further exhaust air via a battery chamber outlet 414 positioned at a higher pressure than the battery chamber inlet 412. In some embodiment, the gradient may further be aided by forced air at any inlet/outlet. Further, the air flow can be separated or routed on a zone basis, such that air from a hotter zone is not drawn to a cooler zone.

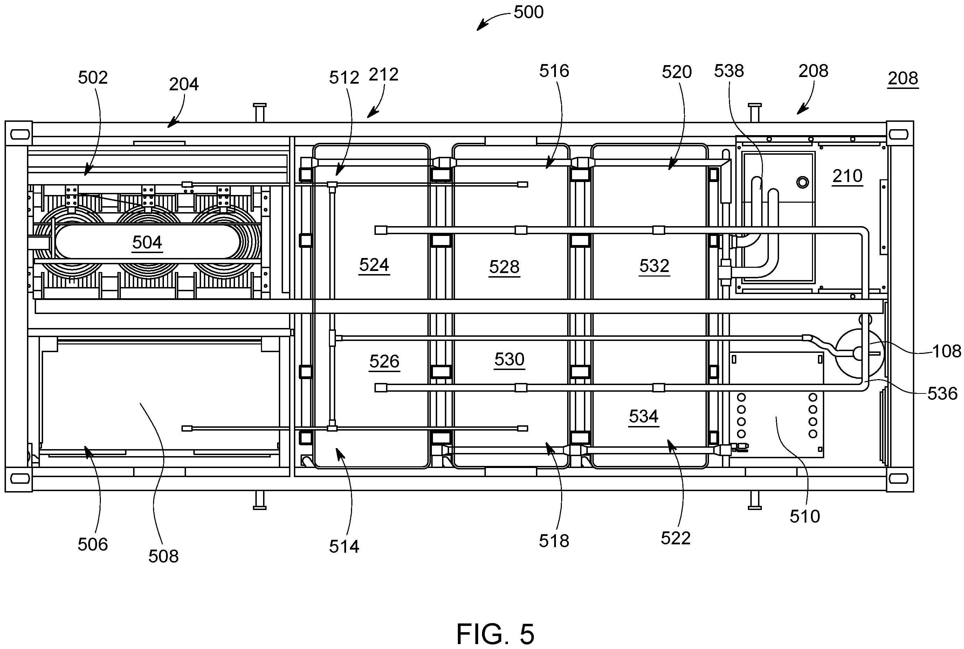

Referring now to FIG. 5, a cutaway diagram 500 of a container 101 is provided according to some embodiments. A power conversion zone 204 of the container 101 includes a first subzone 502 including a first circuit 504 and a second subzone 506 including a second circuit 508 omitting a galvanically isolated device such as a transformer. In some embodiments, the first subzone 502 and second subzone 506 of the power conversion zone 204 extend between opposite faces of the container 101 (e.g., upward and downward, or into and out of the page, as depicted). In some embodiments, the first subzone 502 and second subzone 506 of the power conversion zone 204 extend from one face to a medial or other portion of the container (e.g., less than eight feet for an ISO container). For example, in some embodiments, further circuits may be positioned ahead of or behind the depicted circuits 504, 508 of the power conversion zone 204.

A heat exchange zone 208 includes portions of a cooling system such as a heat exchanger 210 or other components of a chiller. The heat exchange zone 208 can include a processor of the battery management system 510 (e.g., a rack-level control device). Such a system can couple with a user interface panel positioned along an exterior surface of the container 101. The heat exchange zone 208 can include further components, such as a control portion of the fire suppression system 108.

An energy storage zone 212 includes subzones for energy storage modules. Depicted are a first subzone 512, second subzone 514, third subzone 516, fourth subzone 518, fifth subzone 520, and sixth subzone 522, to include corresponding battery modules such as a respective first battery rack 524, second battery rack 526, third battery rack 528, fourth battery rack 530, fifth battery rack 532, and sixth battery rack 534. The energy storage zone 212 can include additional subzones for additional battery modules or other components above, below, in front of, or behind the depicted portions, as is shown with regard to FIGS. 6A-6D. In some embodiments, the energy storage zone 212 may be arranged into a different number of subzones (e.g., two subzones, three subzones, or four subzones).

A fire suppression circuit 536 can couple with each of the subzones for the battery modules, and may further couple with other components (e.g., circuits of the PCS 104). An inter-zone distribution system may further bus a DC link throughout the CESS 100 (e.g., at least between the power conversion zone 204 and energy storage zone 212). The inter-zone distribution system can include a refrigeration circuit 538 throughout the system, as may include the PCS 104 of the power conversion zone 204, battery cells of the energy storage zone 212, and the heat exchanger 210 of the heat exchange zone 208.

FIG. 6A is an isometric view of battery packs 604 in an energy storage zone 212 including various subzones of the container 101, according to some embodiments. Particularly, the view depicts a populated instance of the energy storage zone 212 of FIG. 5. A series of mounting rails 602 are provided to receive the battery packs 604, the mounting rails 602 coupled to and supported by a frame assembly member 606. Although electrical, coolant, or fire suppression circuits are not depicted, the battery packs 604 may be arrayed into racks, such as a first rack 608 and second rack 610 of a corresponding first subzone 512 and second subzone 514 according to an electrical connection between the battery packs 604. For example, the racks of the first subzone 512 and second subzone 514 may be connected in series to form a nine-pack series string (e.g., a 396S according to a forty-four-cell battery pack 604). A battery box 607 may be provided on a per pack, per rack, or per string basis. The battery box 607 can house high voltage equipment such as connectors, fuses, and relays (e.g., to connect to the DC link or the battery combiner). Further racks can include battery modules, depicted as a first column 612, second column 614, and third column 616.

Further strings may be formed from addition modules, such as via a series connection of the third rack 528 and forth rack 530 to form a second string, and a series connection of the fifth rack 532 and sixth rack 534 to form a third string. Additional strings can be formed with battery modules of additional subzones to form a 6P396S bank.

Referring now to FIG. 6B, a top view of the battery packs 604 in the energy storage zone 212 of the container 101 of FIG. 5 are provided, according to some embodiments. For example, depicted are the first string 632, second string 634, third string 636, fourth string 638, fifth string 640, and sixth string 642. In some embodiments, strings may be populated according to various quantities and arrangements of the battery modules. For example, some strings may not be populated with battery modules, relative to a fully populated system. For example, the second string 634 and fifth string 640 may be omitted for a 4P396S bank to decrease weight, current capacity, or improve airflow, relative to the 6P396S bank.

FIG. 6C depicts an isometric view of a portion of the battery packs 604 in the energy storage zone 212 of the container 101 provided in FIG. 6A, according to some embodiments. Relative to FIG. 6A, the second string 634 is depicted as unpopulated and an upper rack of the other strings are depicted as unpopulated. Such a depiction may more clearly illustrate the visible battery packs 604. In some embodiments, such non-population can form a 5P220S bank, as may reduce total weight or increase cooling relative to fully populated instances (e.g., as depicted in FIG. 6A). FIG. 6D depicts an isometric view of a portion of the battery packs in the energy storage zone 212 of the container 101 provided in FIG. 6A, according to some embodiments. Relative to FIG. 6A, the second string 634, fourth string 638, and sixth string 642 are depicted as unpopulated and an upper rack of the other strings are depicted as unpopulated. Such a depiction may more clearly illustrate the visible battery packs 604. In some embodiments, such non-population can form a 3P220S system, as may reduce total weight or increase cooling relative to fully populated instances (e.g., as depicted in FIG. 6A). Further examples can vary according to populations of battery modules or according to a selection of racks of different sizes, or other series/parallel configurations of banks to create electrical connections for various length of strings or number or parallel strings. The various series strings can adjust a voltage. For example, battery cells of the battery modules can be provided with a nominal voltage of 3.2 volts, such that the 220S strings can supply 704V nominal DC link voltage and the 396S strings can supply 1267 volts.

FIG. 7 is a block diagram illustrating an architecture for a computer system that can be employed to implement elements of the systems and methods described and illustrated herein. The computer system or computing device 700 can include or be used to implement a controller 110 or its components, or other components of the CESS 100. The computing system 700 includes at least one bus 705 or other communication component for communicating information and at least one processor 710 or processing circuit coupled to the bus 705 for processing information. The computing system 700 can also include one or more processors 710 or processing circuits coupled to the bus for processing information. The computing system 700 also includes at least one main memory 715, such as a random-access memory (RAM) or other dynamic storage device, coupled to the bus 705 for storing information, and instructions to be executed by the processor 710. The main memory 715 can be used for storing information during execution of instructions by the processor 710. The computing system 700 can further include at least one read only memory (ROM) 720 or other static storage device coupled to the bus 705 for storing static information and instructions for the processor 710. A storage device 725, such as a solid-state device, magnetic disk or optical disk, can be coupled to the bus 705 to persistently store information and instructions (e.g., for the data repository 120).

The computing system 700 can be coupled via the bus 705 to a display 735, such as a liquid crystal display, or active-matrix display. An input device 730, such as a keyboard or mouse can be coupled to the bus 705 for communicating information and commands to the processor 710. The input device 730 can include a touch screen display 735.

The processes, systems and methods described herein can be implemented by the computing system 700 in response to the processor 710 executing an arrangement of instructions contained in main memory 715. Such instructions can be read into main memory 715 from another computer-readable medium, such as the storage device 725. Execution of the arrangement of instructions contained in main memory 715 causes the computing system 700 to perform the illustrative processes described herein. One or more processors in a multi-processing arrangement can also be employed to execute the instructions contained in main memory 715. Hard-wired circuitry can be used in place of or in combination with software instructions together with the systems and methods described herein. Systems and methods described herein are not limited to any specific combination of hardware circuitry and software.

Although an example computing system has been described in FIG. 7, the subject matter including the operations described in this specification can be implemented in other types of digital electronic circuitry, or in computer software, firmware, or hardware, including the structures disclosed in this specification and their structural equivalents, or in combinations of one or more of them.

Referring now to FIG. 8, a flow chart illustrating a method 800 of energy control for a containerized energy storage system 100 is provided, according to some embodiments. The method 800 includes various branches which can refer to actions taken with regard to one or more circuits, or for one or more modes of operation. For example, the controller 110 can execute the various of the operations according to instructions stored on a non-transitive computer readable memory.

At operation 802, a controller 110 of the CESS 100 can conduct a self-check operation. The self-check operation can determine a population of any zones (e.g., subzones), a determination of any selected modes of operation (e.g., according to a configuration files, or other controls, such as controls of a user interface). In some embodiments, the self-check operation can include determining a presence, type, or condition of any connected equipment, or components of the CESS 100.

At decision block 804, a controller 110 of the CESS 100 can determine if a renewable energy source 304 is available. If a renewable energy source 304 is available, the controller 110 can cause the CESS 100 to proceed to operate with the renewable energy source 304 (e.g., in an embodiment where the renewable energy source 304 and the CESS both supply a load device 134). In some embodiments, the CESS 100 proceeds to operate in a PQ mode according to an instruction of the controller 110 (at operation 806) following the renewable energy source 304. In some embodiment, the CESS 100 proceeds to operate in a VF mode according to an instruction of the controller 110 (e.g., where the renewable energy source 304 is not a grid forming source).

Referring to decision block 808, a controller 110 of the CESS 100 determines if power supplied by a renewable energy source 304 is less than a threshold (e.g., twenty percent of capacity). If the controller 110 determines that the green energy exceeds the threshold, the controller 110 can cause the CESS 100 to continue with PQ operation at operation 806. If the controller 110 determines that the green energy does not meet the threshold, to method 800 proceeds to decision block 810.

At decision block 810, the controller 110 of the CESS 100 determines whether a backup source is available. If a backup green source is available, the method 800 proceeds to operation 812 and the CESS 100 continues to operate in parallel with the backup source (e.g., in a following mode according to the depicted embodiment, or a leading mode in some other embodiments). If no green backup is available, the method 800 can proceed to operation 814, where the controller 110 can start another source such as a generator set 302 or to draw additional power from the CESS 100.

Referring now to decision block 820, the controller 110 of the CESS 100 determines if a generator set 302 is available. If the generator set 302 is available, the controller 110 of the CESS 100 can cause the generator set 302 to start and deliver energy in combination with the CESS 100 (e.g., according to a hybrid circuit) at operation 822. At decision block 824, the controller 110 of the CESS 100 determines if an eco-mode is enabled. For example, such a determination can depend on a CESS SoC and load demand. For example, the controller 110 can enable an economy mode according to a threshold of the SoC of the CESS 100 (where the SoC of the CESS 100 exceeds a threshold of the threshold data 124) or a load demand (e.g., where power available exceeds a threshold percentage of power demand). Conversely, the controller 110 can disable the economy mode where the SoC or demand is less than a threshold. The threshold may be symmetric or can introduce hysteresis between enabling and disabling the economy mode. Where an economy mode is enabled, the controller 110 of the CESS 100, at operation 826, operates the generator set 302 in the economy mode (e.g., operating in an efficiency band) and supplies or retrieves energy from the generator set 302 according to an availability. Where the economy mode is enabled, the controller 110 of the CESS 100, at operation 828, operates the generator set 302 in a power mode (e.g., operating in a power band).

Referring now to decision block 840, the controller 110 of the CESS 100 determines if a battery supply mode is enabled. Where the battery supply mode is enabled, the CESS 100 can proceed to an operational state at operation 842 (e.g., in a follower mode as depicted, or in a leading/grid forming mode according to an indication received by the controller 110 at operation 802). At operation 844, upon a detection of a fault, the controller 110 of the CESS 100 proceeds to a halt state. Although shown as transitioning to operation 844 from operation 842, the controller 110 can implement further transitions according to detected conditions (e.g., can transition to the halt state of operation 844 from any of the depicted operations). In some embodiments, at operation 844, the controller 110 implements a resolution loop, such as via an isolation of one or more battery cells, implementing a wait time to cool a component below a threshold, or otherwise resolve a condition. In some embodiments, a return from operation 844 (e.g., to operation 802) includes a user entry or automatic state change executed by the controller 110. In some embodiments, at least a portion of the depicted operations correspond to a state of a finite state machine implemented by the controller 110.

At decision block 846, the controller 110 of the CESS 100 determines if a SoC is below a threshold (e.g., 25%, 50%, or another value). If the SoC is not below the threshold, the method 800 continues to operate at operation 842. If the SoC is below the threshold, the method 800 proceeds to decision block 848. At decision block 848, the CESS 100 compares a load to a capacity. Where the load is not less than the threshold portion of the capacity (e.g., 80%), the controller 110 causes the CESS 100 to continue to provide power until the SoC reaches another threshold, less than the threshold of operation 844 (e.g., 5% or 10%) at operation 852. Where the load is less than the threshold portion of capacity, the method 800 proceeds to operation 850, where the controller 110 causes the CESS 100 to charge batteries (e.g., to a predefined threshold value, which may be equal to or less than a full SoC). That is, the controller 110 can be configured to receive an indication of power availability from a source device 132 configured to receive the AC output power signal and detect an SoC of the energy storage system 102 of the CESS 100. Based on the indication and the SoC, the controller 110 can select between the provision of an AC output power signal (e.g., a power output mode) and a DC output power signal (e.g., a recharge mode).

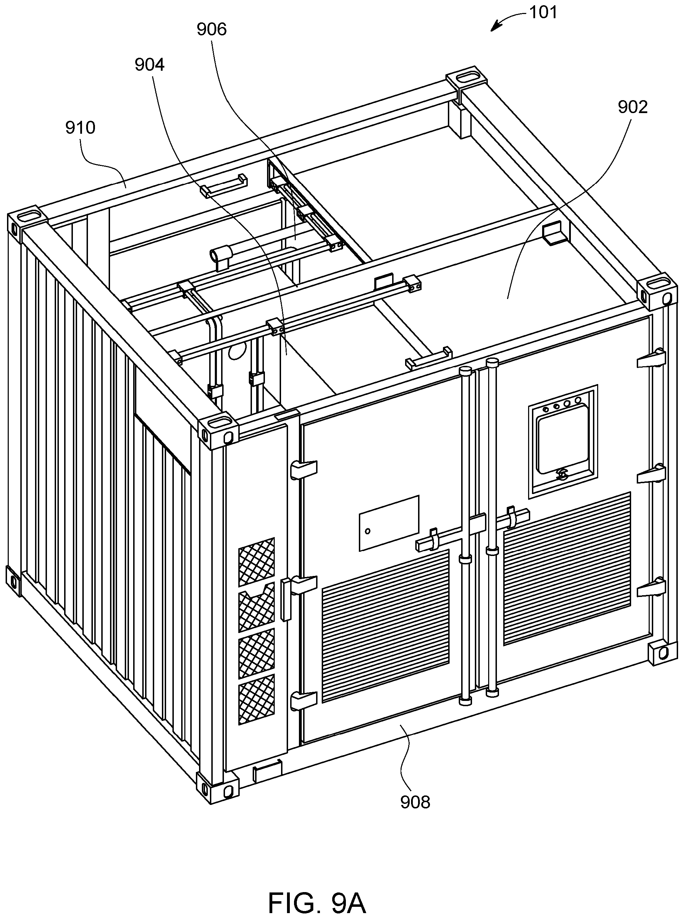

FIG. 9A is an isometric view of a container 101, according to some embodiments. The container 101 includes a power conversion zone 902 configured to receive components of one or more circuits of a PCS 104. For example, the power conversion zone 902 can include any of the components of the power conversion zone 204 of FIG. 2. The container 101 includes a heat exchange zone 904 to receive a heat exchanger 210. For example, the heat exchange zone 904 can include any of the components of the heat exchange zone 208 of FIG. 2. The container 101 includes an energy storage zone 906 to receive components of an energy storage system 102 (e.g., a battery storage system 203). For example, the energy storage zone 906 can include any of the components of the energy storage zone 212 of FIG. 2. The power conversion zone 902 abuts an opposite face of the container 101 as the heat exchange zone 904.

The container 101 is configured for energy delivery and includes a battery storage system 203 in an energy storage zone 906 of the container 101. The container 101 includes a PCS 104 in a power conversion zone 902 along a first face of the container 101 (e.g., front face 908 as depicted). The PCS 104 can be configured to (e.g., can include one or more circuits and/or circuitry to convert) an AC input power signal to a DC output power signal and an AC output power, the DC output power signal configured to recharge battery cells of the battery system 203. The container 101 includes a heat exchanger 210 in a heat exchange zone 904 along a second face of the container 101.

With further reference to the (unitary) container 101, a first nominal dimension of the opposite faces of the power conversion zone 902 and the heat exchange zone 904 is three meters (ten feet), according to the depicted embodiment of FIG. 9A. The depicted vertical dimension perpendicular thereto is 2.6 meters (eight feet six inches), and the remaining perpendicular dimension is 2.4 meters (eight feet). Such nominal dimensions may be exclusive of flaps, hoods, and the like. However, such portions may be removable to ease in the transportation thereof. For example, the container 101 can include a storage area to include such components.

In some embodiments, the container 101 includes or interfaces with a fire suppression system 108. For example, the container 101 can include a user interface for a fire suppression system 108 at the first face or the second face (e.g., opposite faces of the power conversion zone 902 and the heat exchange zone 904), such as at one of the first face or the second face. The user interface may be configured to receive an input to cause the fire suppression system 108 to discharge a suppression agent configured to manage thermal events of the battery system 203.

In some embodiments, the energy storage system 102 is a battery system 203 including battery cells in the energy storage zone 906. The battery cells may be thermally coupled with a fluid (e.g., to exchange heat between the battery cells and a heat exchanger 210 of a cooling system). In some embodiments, the second face of the container 101 (e.g., a rear face 910), is opposite from the first face. The heat exchanger 210 can be configured to receive a fluid from the energy storage zone 906, the energy storage zone 906 positioned between the first face and the second face of the container 101. The heat exchanger 210 can transfer heat from the fluid to an exterior face of the container 101 to cause the heat to be exhausted out of the exterior face. In some embodiments, the container 101 includes a coolant loop including a fluid channel configured to convey a fluid between the heat exchanger and the battery system 203. The container 101 can include a fan configured to exhaust air to generate negative pressure within the container 101.

The container 101 (e.g., the energy storage zone 906) can include multiple (e.g., a plurality of sub-zones). The sub-zones can include mounting rails 602 and assembly members 606 configured to receive various energy storage modules (e.g., battery packs 604) of the battery system 203. Each energy storage module of plurality of the energy storage modules can include a plurality of battery cells. A DC link (e.g., of the PCS) can be coupled with multiple energy storage modules of the plurality of energy storage modules, the multiple energy storage modules connected in series.

The DC link can be coupled with multiple of the energy storage modules, the multiple of the energy storage modules being connected in series. In some embodiments, the container 101 includes a cooling system 106 fluidically coupled with each of the plurality of energy storage modules. Each of the energy storage modules can be positioned and/or arranged along, and removable through, an exterior access surface of the container 101 (which may include decoupling fluidic or electrical connections).

The controller 110 can perform operations as described with reference to other instances of a container 101 or associated CESS 100. For example, the controller 110 can detect a quantity of parallel groups of battery cells, and control a rate of charging of the battery system 203 based on the detected quantity. Further, the controller 110 can be configured to receive an indication of power availability from a source device 132 configured to receive the AC output power signal, the indication embedded in the DC output power signal. The controller 110 can detect a SoC of the energy storage system 102 (as previously indicated with reference to the method 800 of FIG. 8). The controller 110 can select between the provision of the AC output power signal and the DC output power signal based on the indication embedded in the DC output power signal and the SoC. Similarly, as indicated with further regard to the method 800 of FIG. 8, the PCS 104 of the power conversion zone 902 can include a first circuit configured to receive energy from the battery system 203 while a second circuit provides energy to the battery system.

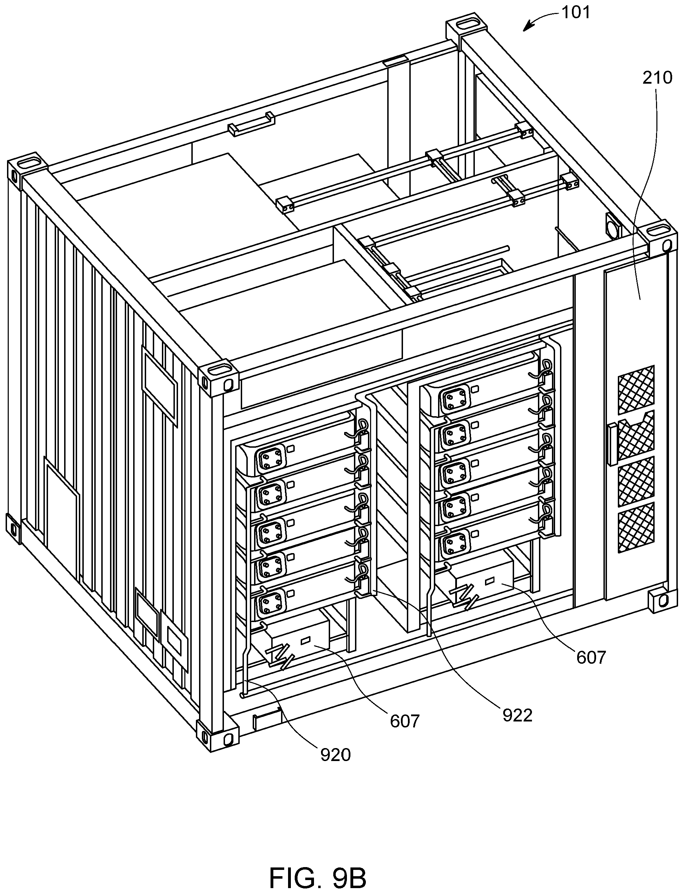

FIG. 9B is the reverse isometric view, relative to FIG. 9A, of a same container 101 as FIG. 9A. As depicted, any of a fire suppression circuit 536, open or closed fluidic coolant circuit (e.g., liquid coolant of a refrigeration circuit 538 including a distinct supply line 920 and return line 922), or electrical connection to a DC link, such as via a battery box 607, can be provided to the battery modules. The provision of the fire suppression circuit 536, refrigeration circuit 538, or electrical connections may be provided directly or via rack members such as mounting brackets, cold plates, air or liquid channels for a refrigerant.

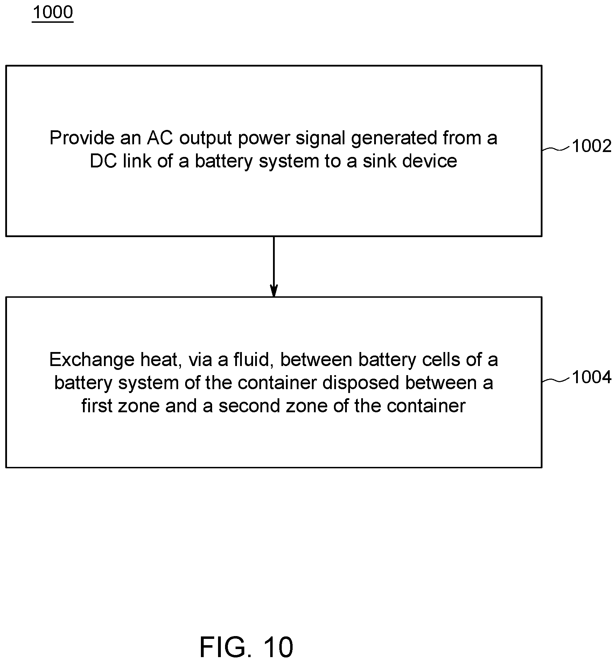

FIG. 10 is a flow chart illustrating a method 1000 of containerized energy delivery for a containerized energy storage system, according to some embodiments. The method 1000 can be performed by one or more systems or components depicted in FIGs. 1-7 or 9A-9B, as provided herein (e.g., the CESS 100 or a controller 110 thereof). The method 1000 can include additional, fewer, or different operations according to various embodiments.

At operation 1002, the method 1000 includes providing, via power conversion circuitry in a power conversion zone of a container, an alternating current (AC) output power signal generated from a battery system 203. The provision of the AC output power signal can be performed at (or defined by) a mode of operation.

The first mode of operation may refer to one of various modes of operation for the CESS 100. The method 1000 can include alternating between multiple modes of operation according to detected conditions of or related to the CESS 100 (e.g., according to operation of the controller 110). For example, the method 1000 can include receiving an indication of a cessation of the mode of operation corresponding to the provision of the AC output power signal (e.g., according to any of the threshold data 124). Responsive to the indication, the method 1000 can include terminating the provision of the AC output power signal to charge the battery cells of the battery system 203 using energy received from a source device.

The controller 110 can operate within or between modes of operations according to detected conditions of the CESS 100 (e.g., temperatures, currents, voltages, or populations associated therewith). For example, the controller 110 can detect a quantity of battery modules and control a charging rate or discharging rate of the battery system 203 based on the detected quantity.

At operation 1004, the method 1000 includes exchanging heat generated by the power conversion circuitry, via a fluid (e.g., a liquid refrigerant), between battery cells of the battery system 203 and an exterior face of the container, the battery cells disposed in an energy storage zone of the container 101 disposed between the power conversion zone 204 and a heat exchange zone 208, and an exterior face of the container. The battery cells may be positioned in an energy storage zone of the container 101, the energy storage zone positioned between the power conversion zone and a heat exchange zone. The battery cells may be electrically coupled with the DC link (e.g., to provide energy thereto or receive energy therefrom). In some embodiments, the method 1000 includes circulating the fluid via a closed loop including a heat exchanger along the exterior face.

According to a condition of the CESS 100 or interfacing components, the method 1000 can include operation of any other of the components discussed herein. The operations can execute according to controller 110 instructions. For example, in some embodiments, the controller monitors a first condition of the container (e.g., a temperature, or detection of flame or smoke). The controller 110 further monitors a second condition of a user interface positioned on any face (e.g., a first face or a second face) of the container 101, in some embodiments. In some embodiments, the controller 110 generates a control signal for a fire suppression system 108 based on the first condition and the second condition (e.g., a logical OR thereof).

As utilized herein, the terms "approximately," "about," "substantially," and similar terms are intended to have a broad meaning in harmony with the common and accepted usage by those of ordinary skill in the art to which the subject matter of this disclosure pertains. It should be understood by those of skill in the art who review this disclosure that these terms are intended to allow a description of certain features described and claimed without restricting the scope of these features to the precise numerical ranges provided. Accordingly, these terms should be interpreted as indicating that insubstantial or inconsequential modifications or alterations of the subject matter described and claimed are considered to be within the scope of the disclosure as recited in the appended claims.

It should be noted that the term "exemplary" and variations thereof, as used herein to describe various embodiments, are intended to indicate that such embodiments are possible examples, representations, or illustrations of possible embodiments (and such terms are not intended to connote that such embodiments are necessarily extraordinary or superlative examples).

The term "coupled" and variations thereof, as used herein, means the joining of two members directly or indirectly to one another. Such joining can be stationary (e.g., permanent or fixed) or moveable (e.g., removable or releasable). Such joining can be achieved with the two members coupled directly to each other, with the two members coupled to each other using one or more separate intervening members, or with the two members coupled to each other using an intervening member that is integrally formed as a single unitary body with one of the two members. If "coupled" or variations thereof are modified by an additional term (e.g., directly coupled), the generic definition of "coupled" provided above is modified by the plain language meaning of the additional term (e.g., "directly coupled" means the joining of two members without any separate intervening member), resulting in a narrower definition than the generic definition of "coupled" provided above. Such coupling can be mechanical, electrical, or fluidic. For example, circuit A communicably "coupled" to circuit B can signify that the circuit A communicates directly with circuit B (i.e., no intermediary) or communicates indirectly with circuit B (e.g., through one or more intermediaries).

References herein to the positions of elements (e.g., "top," "bottom," "above," "below") are merely used to describe the orientation of various elements in the FIGURES. It should be noted that the orientation of various elements can differ according to other exemplary embodiments, and that such variations are intended to be encompassed by the present disclosure.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

Although the figures and description may illustrate a specific order of method steps, the order of such steps may differ from what is depicted and described, unless specified differently above. Also, two or more steps may be performed concurrently or with partial concurrence, unless specified differently above. Such variation may depend, for example, on the software and hardware systems chosen and on designer choice. All such variations are within the scope of the disclosure. Likewise, software implementations of the described methods could be accomplished with standard programming techniques with rule-based logic and other logic to accomplish the various connection steps, processing steps, comparison steps, and decision steps.

It is important to note that the construction and arrangement of the CESS 100 as shown in the various exemplary embodiments is illustrative only. Additionally, any element disclosed in one embodiment may be incorporated or utilized with any other embodiment disclosed herein. Although only one example of an element from one embodiment that can be incorporated or utilized in another embodiment has been described above, it should be appreciated that other elements of the various embodiments may be incorporated or utilized with any of the other embodiments disclosed herein.

## Claims

1. A system for containerized energy delivery comprising:
a container comprising:
an energy storage system;
a power conversion system in a power conversion zone along a first face of the container, the power conversion system configured to convert an AC input power signal to a DC output power signal and to an AC output power signal; and
a cooling system comprising a heat exchanger in a heat exchange zone along a second face of the container, the second face opposite from the first face, the heat exchanger configured to exchange heat between (i) a plurality of components of the energy storage system positioned within the container in an energy storage zone positioned between the heat exchange zone and the power conversion zone, and (ii) an environment exterior to the container.

2. The system of claim 1, wherein:
the power conversion system comprises a DC link;
the plurality of components comprises a plurality of battery cells, the plurality of battery cells coupled with the DC link;
the container comprises a fluid channel in the energy storage zone, the fluid channel configured to transfer the heat to a fluid in the fluid channel; and
the heat exchanger is configured to:
receive the fluid from the fluid channel; and
transfer the heat from the fluid to the environment.

3. The system of claim 2, wherein the power conversion system is configured to generate the AC output power signal and the DC output power signal from the DC link;
or wherein:
the power conversion system comprises a first circuit configured to couple a first output of the power conversion system with the DC link according to a galvanic isolation of a transformer between the first output and the DC link, the transformer positioned in the power conversion zone, the first circuit comprising at least one of:
an inverter configured to generate the AC output power signal using energy received from the DC link; or
a converter configured to generate the DC output power signal using energy received from the DC link; and
the power conversion system comprises a second circuit spaced vertically from the first circuit, the second circuit configured to couple a second output of the power conversion system with the DC link.

4. The system of claim 1, further comprising a controller, wherein the controller is configured to either:
a) cause at least one of the first circuit or the second circuit to transfer energy from the DC link to the energy storage system based on a state of the energy storage system; or
b) detect a quantity and arrangement of a plurality of battery modules stored in a plurality of sub-zones of the energy storage zone; and
control a charging or discharging of the energy storage system based on the detected quantity and arrangement, wherein the energy storage system is a battery storage system and the plurality of components of the energy storage system are battery cells of the plurality of battery modules.

5. The system of any of claims 14, wherein:
a first nominal dimension between the first face and the second face is 6.1 meters (twenty feet);
a second nominal dimension of the container, perpendicular to the first nominal dimension, is 2.6 meters (eight feet six inches); and
a third nominal dimension of the container, perpendicular to the first nominal dimension and the second nominal dimension, is 2.4 meters (eight feet).

6. The system of claim 12, either
- further comprising a controller configured to:
receive an indication of power availability from a source device configured to receive the AC output power signal;
detect a state of charge (SoC) of the energy storage system; and
select between the provision of the AC output power signal and the DC output power signal based on the indication and the SoC;
or
- wherein the power conversion system further comprises a plurality of circuits comprising:
a first circuit configured to provide the AC output power signal simultaneously to the provision, by a second circuit, of the DC output power signal; and
the second circuit.

7. The system of claim 2, wherein the heat exchanger is a condenser of a chiller, the fluid comprises a refrigerant, and the cooling system further includes a compressor configured to compress the refrigerant.

8. A container for energy delivery comprising:
a battery system in an energy storage zone of the container;
a power conversion system in a power conversion zone along a first face of the container, the power conversion system configured to convert an AC input power signal to a DC output power signal and an AC output power signal, the DC output power signal configured to recharge battery cells of the battery system; and
a heat exchanger in a heat exchange zone along a second face of the container.

9. The container of claim 8, wherein:
a first nominal dimension between opposite faces of the power conversion zone and the heat exchange zone is 3 meters (ten feet);
a second nominal dimension of the container, perpendicular to the first nominal dimension, is 2.6 meters (eight feet six inches); and
a third nominal dimension of the container, perpendicular to the first nominal dimension and the second nominal dimension, is 2.4 meters (eight feet);
and optionally wherein the battery cells are thermally coupled with a fluid; and
the container comprises a user interface for a fire suppression system at one of the first face or the second face, the user interface configured to receive an input to cause the fire suppression system to discharge a suppression agent configured to manage thermal events of the battery system.

10. The container of claim 8, wherein the second face is opposite from the first face, the heat exchanger configured to:
receive a fluid from the energy storage zone of the container, the energy storage zone positioned between the first face and the second face; and
transfer heat from the fluid to an exterior face of the container to cause the heat to be exhausted out of the exterior face.

11. The container of claim 8, wherein the container comprises:
a coolant loop comprising a fluid channel configured to convey a fluid between the heat exchanger and the battery system; and
a fan configured to exhaust air to generate negative pressure within the container;
and optionally wherein the container comprises :
a plurality of sub-zones comprising mounting rails and assembly members configured to receive a plurality of energy storage modules of the battery system, each energy storage module of the plurality of energy storage modules comprising a plurality of battery cells, wherein:
a DC link is coupled with multiple energy storage modules of the plurality of energy storage modules, the multiple energy storage modules connected in series;
and further optionally wherein the container comprises a cooling system fluidically coupled with each of the plurality of energy storage modules, via a fluid coupling of each of the plurality of energy storage modules, wherein each of the plurality of energy storage modules are arranged along, and are removable through, an exterior access surface of the container.

12. The container of claim 8, further comprising a controller configured to either:
a) detect a quantity of parallel groups of battery cells; and
control a rate of charging of the battery system based on the detected quantity; or
b) receive an indication of power availability from a source device configured to receive the AC output power signal, the indication embedded in the DC output power signal;
detect a state of charge (SoC) of the battery system; and
select between the provision of the AC output power signal and the DC output power signal based on the indication embedded in the DC output power signal and the SoC.

13. The container of claim 8, wherein the power conversion system comprises a first circuit and a second circuit, the first circuit configured to receive energy from the battery system while the second circuit provides energy to the battery system.

14. A method for containerized energy delivery comprising:
providing, via power conversion circuitry in a power conversion zone of a container, an alternating current (AC) output power signal generated from a battery system; and
exchanging heat generated by the power conversion circuitry, via a fluid, between battery cells of the battery system and an exterior face of the container, the battery cells positioned in an energy storage zone of the container, the energy storage zone positioned between the power conversion zone and a heat exchange zone.

15. The method of claim 14, further comprising at least one of:
a) receiving an indication of a cessation of a mode of operation corresponding to the provision of the AC output power signal;
terminating, responsive to the indication, the provision of the AC output power signal; and
providing, subsequent to the termination, a DC power signal to charge the battery cells of the battery system using energy received from a source device;
b) circulating the fluid via a closed loop including a heat exchanger along the exterior face;
c) detecting a quantity of battery modules; and
controlling a charging rate or discharging rate of the battery system based on the detected quantity;
and
d) monitoring, via a controller, a first condition of the container;
monitoring, via the controller, a second condition of a user interface positioned at one of a first face or a second face; and
generating a control signal for a fire suppression system based on the first condition and the second condition.
